# EUROPÄISCHE PATENTANMELDUNG

(11) **EP 4 654 024 A1**
(43) Veröffentlichungstag der Anmeldung: **26.11.2025**
(21) Anmeldenummer: 24177426.4
(22) Anmeldetag: 22.05.2024
(51) Int. Cl.: G06F 11/36, G06F 30/20

(54) **COMPUTERIMPLEMENTIERTES VERFAHREN ZUM ANALYSIEREN UND/ODER ANPASSEN EINES BETRIEBS EINER TECHNISCHEN ANLAGE**

(71) Anmelder: Siemens Aktiengesellschaft, 80333 München (DE)
(72) Erfinder: Puntel Schmidt, Philipp, 90453 Nürnberg (DE); Witte, Martin, 91126 Schwabach (DE)
(74) Vertreter: Siemens Patent Attorneys

(57) **Zusammenfassung**

Die Erfindung betrifft ein computerimplementiertes Verfahren zum Analysieren und/oder Anpassen eines Betriebs einer technischen Anlage (3) mit einer Anzahl von Anlagenkomponenten (31, 32) und eines Steuergeräts (4) zum Steuern der technischen Anlage. Das Verfahren umfasst; Erlangen (S10) eines Quellcodes (42) einer auf dem Steuergerät ausgeführten Steuerfunktionalität und Extrahieren von Codeartefakten aus dem erlangen Quellcode; Durchführen (S20) einer Analyse der extrahierten Codeartefakte und Bestimmen eines hinreichenden Detaillierungsgrads eines Modells zum Modellieren einer jeweiligen der Anlagenkomponenten basierend auf der durchgeführten Analyse; und Bereitstellen (S30) eines digitalen Zwillings (5) der technischen Anlage zur Verwendung beim Analysieren und/oder Anpassen des Betriebs der technischen Anlage, der für jede der Anlagenkomponenten ein gemäß dem jeweiligen bestimmten Detaillierungsgrad generiertes Modell (51, 52) umfasst.

Die Erstellung unnötig detaillierter digitaler Zwinge wird vermieden, so dass auch bei geringer Losgröße eine Anpassung des Anlagenbetriebs mittels digitaler Zwillinge möglich wird.

## Beschreibung

Die vorliegende Erfindung betrifft das Gebiet der industriellen Steuerungstechnik und im Speziellen ein Verfahren und eine Vorrichtung zum Analysieren und/oder Anpassen eines Betriebs einer technischen Anlage, die sich für Analysen und Anpassungen in Brownfield-Szenarien mit geringen Losgrößen bis hin zu Losgröße 1 eignen.

Eine technische Anlage weist typischerweise ein Steuergerät, wie beispielsweise eine speicherprogrammierbare Steuerung (SPS), auf, welches dafür benutzt wird, Funktionen, wie etwa diskrete Fertigungsprozesse, der technischen Anlage zu steuern. Derartige Steuergeräte enthalten mitunter sehr komplexe Softwareprojekte, in denen die zu automatisierenden Funktionen der technischen Anlage programmiert sind.

Außerdem sind digitale Zwillinge bekannt. Ein digitaler Zwilling modelliert und simuliert Eigenschaften der technischen Anlage, bildet ihr Verhalten nach und stellt Signaleingänge und - ausgänge bereit, die jenen der technischen Anlage entsprechen. Somit kann aus dem physikalischen Steuergerät und dem digitalen Zwilling der technischen Anlage eine Hardware-in-the-Loop-Anordnung ausgebildet werden, anhand derer Simulationsstudien durchgeführt werden können. Ein solcher digitaler Zwilling kann für eine virtuelle Inbetriebnahme im Sinne der Richtlinie VDI/VDE 3693 verwendet werden. Hierbei wird die Programmierung des Steuergeräts erprobt und ggf. abgeändert, bevor das Steuergerät mit einer realen technischen Anlage in Betrieb genommen wird. Ein weiterer digitaler Zwilling kann für Logistikuntersuchungen, präemptive Instandhaltung und dergleichen verwendet werden.

Bei der Nutzung von digitalen Zwillingen ist es üblich, diese für den jeweiligen Anwendungsfall neu zu erstellen oder für den jeweiligen Anwendungsfall spezifisch anzupassen. Allgemeingültige digitale Zwillinge existieren im Anlagenbau aufgrund der Charakteristik des Anlagenbaus, in dem Losgrößen von 1 die Regel sind, nicht oder nur in Ausnahmefällen, wobei selbst bei Vorliegen eines generischen digitalen Zwillings für eine gewisse Klasse von Anlagen eine gewisse Anpassung auf die konkrete Anlage stets notwendig ist.

Der Aufwand zur Erstellung eines digitalen Zwillings ist herkömmlicherweise hoch. Herkömmlich werden meist sehr realitätsgetreue digitale Zwillinge mit hohem Detaillierungsgrad erstellt, da dem Modellierer der tatsächlich hinreichende Detaillierungsgrad nicht bekannt ist. In einem Brownfield-Szenario, in dem der Betrieb einer einzelnen, bereits in Betrieb genommenen technischen Anlage analysiert und/oder verändert werden soll, wird wegen des hohen Aufwands zur Modellerstellung herkömmlicherweise meist Abstand von der Nutzung eines digitalen Zwillings zur Analyse oder Anpassung des Betriebs genommen.

Die VDI/VDE 3693 benennt im Zusammenhang mit der virtuellen Inbetriebnahme die Möglichkeit zur Verwendung unterschiedlicher Modellarten von unterschiedlichem Detaillierungsgrad (unterschiedlicher Modellierungstiefe).

Barth, Mike: "Automatisch generierte Simulationsmodelle verfahrenstechnischer Anlagen für den Steuerungstest", Fortschritt-Berichte VDI Reihe 20 Nr. 438: Rechnerunterstützte Verfahren, Düsseldorf: VDI Verlag 2011, offenbart das automatische Generieren eines Simulationsmodells für einen Steuerungstest in einer Hardware-in-the-Loop-Anordnung.

Der Erfinder der vorliegenden Offenbarung offenbart in Puntel-Schmidt, Philipp, "Methoden zur simulationsbasierten Absicherung von Steuerungscode fertigungstechnischer Anlagen", Dissertation, 2017, DOI 10.24405/4182, ein Verfahren zur automatisierten Modellgenerierung von Anlagensimulationsmodellen für die virtuelle Inbetriebnahme, in dessen Rahmen anhand eines vorhandenen Anlagenstrukturmodells sowie einer Simulationsmodellbibliothek, die Teil-Simulationsmodelle in mehreren verschiedenen Detaillierungsgraden umfasst, automatisch ein als digitaler Zwilling verwendbares Modell generiert wird. Es bleibt jedoch dem Urteil eines menschlichen Anwenders überlassen, den jeweils erforderlichen Detaillierungsgrad festzulegen.

Vor diesem Hintergrund liegt der Erfindung als Aufgabe zugrunde, das Analysieren und/oder Anpassen eines Betriebs einer bereits in Betrieb genommenen technischen Anlage zu vereinfachen.

Demgemäß wird unter einem ersten Aspekt ein computerimplementiertes Verfahren zum Analysieren und/oder Anpassen eines Betriebs einer technischen Anlage mit einer Anzahl von Anlagenkomponenten und eines Steuergeräts zum Steuern der technischen Anlage vorgeschlagen. Das Verfahren umfasst: a) Erlangen eines Quellcodes einer auf dem Steuergerät ausgeführten Steuerfunktionalität und Extrahieren von Codeartefakten aus dem Quellcode; b) Durchführen einer Analyse der in Schritt a) extrahierten Codeartefakte und Bestimmen eines hinreichenden Detaillierungsgrads eines Modells zum Modellieren einer jeweiligen Anlagenkomponente basierend auf der durchgeführten Analyse; und c) Bereitstellen eines digitalen Zwillings der technischen Anlage zur Verwendung beim Analysieren und/oder Anpassen des Betriebs der technischen Anlage, wobei der digitale Zwilling für jede der Anlagenkomponenten der technischen Anlage ein entsprechendes Modell umfasst, das gemäß dem jeweiligen in Schritt b) bestimmten Detaillierungsgrad generiert ist.

Demgemäß ist ein vorteilhaftes Verfahren angegeben, mit dem sich für eine, insbesondere eine bereits in Betrieb genommene, technische Anlage vollautomatisch ein digitaler Zwilling erzeugen und bereitstellen lässt, der Modelle von adäquatem Detaillierungsgrad aufweist und sich dazu eignet und dafür vorgesehen ist, in einem Hardware-in-the-Loop-Szenario Analysen des Anlagenbetriebs durchzuführen und Änderungen des Anlagenbetriebs, das heißt Änderungen an den Anlagenkomponenten und/oder an der Steuerfunktionalität des Steuergeräts, vor deren Übernahme auf die technische Anlage zu erproben.

Durch eine solchermaßen automatisierte und vereinfachte Bereitstellung des digitalen Zwillings wird auch für kleine und mittelständische Unternehmen, die eine einzelne spezialisierte technische Anlage (Losgröße 1) in Betrieb haben, vorteilhafterweise der Einsatz eines digitalen Zwillings zur Analyse und Änderung des Betriebs dieser technischen Anlage in einem Brownfield-Szenario möglich gemacht.

Eine Überlegung der Erfinder besteht darin, dass die auf dem Steuergerät ausgeführte Steuerfunktionalität einer bereits in Betrieb befindlichen technischen Anlage die technische Anlage mit der durch die physikalischen Gegebenheiten in der technischen Anlage erforderlichen Präzision steuert und/oder regelt. Somit kann durch eine automatisierte Analyse des Quellcodes dieser Steuerfunktionalität ein hinreichender Detaillierungsgrad für die Modelle des digitalen Zwillings der technischen Anlage, bei welchem die physikalischen Gegebenheiten der technischen Anlage mit der erforderlichen Detailtreue modelliert werden, zuverlässig ermittelt werden.

Bereitstellen eines digitalen Zwillings umfasst beispielsweise, die jeweiligen Modelle auf einer Computervorrichtung, welche mit dem Steuergerät der technischen Anlage zu einer Hardware-in-the-Loop-Anordnung verbindbar ist, automatisch zu konfigurieren und/oder zu installieren und/oder zur Ausführung zu bringen.

Die jeweiligen Modelle können hierbei beispielsweise aus einer Modellbibliothek bezogen werden, die Modelle unterschiedlichen Detaillierungsgrads für jeweilige Anlagenkomponenten speichert, wie von Puntel-Schmidt in DOI 10.24405/4182 beschrieben, wobei der jeweils erforderliche und hinreichende Detaillierungsgrad von dem vorgeschlagenen Verfahren automatisiert durch Codeanalyse der Steuerfunktionalität ermittelt wird.

Der Begriff "Anlagenkomponente" bezeichnet vorliegend einen Teilabschnitt der technischen Anlage von beliebiger sachdienlicher Granularität. Es kann sich also bei einer Anlagenkomponente um ein einzelnes Stellglied, eine einzelne technische Vorrichtung oder um eine Baugruppe oder Anordnung aus mehreren zusammenwirkenden technischen Vorrichtungen handeln, die in der technischen Anlage umfasst sind.

Das Steuergerät kann eine speicherprogrammierbare Steuerung, ein Industrie-PC oder jede andere geeignete Steuervorrichtung sein. Der Begriff "Steuergerät" kann auch eine Vielzahl von zusammenwirkenden Steuervorrichtungen bezeichnen.

Das Steuergerät kann separat von der technischen Anlage bereitgestellt sein oder kann ein Teil der technischen Anlage sein, es versteht sich jedoch, dass das Steuergerät selbst nicht Gegenstand der Modellierung durch den digitalen Zwilling ist.

Der Begriff "Quellcode" bezeichnet insbesondere einen analysierbaren Programmcode eines Programms, bei dessen Ausführung die Steuerfunktionalität auf dem Steuergerät realisiert wird.

Der Begriff "Codeartefakt" bezeichnet insbesondere einen Abschnitt des Quellcodes. Ein Codeartefakt kann insbesondere einen Codebaustein, Definitionen von Schnittstellen des Codebausteins (Schnittstellendefinitionen), und Listen mit Definitionen von Eingangssignalen und Ausgangssignalen umfassen.

Der Quellcode und die jeweiligen Codeartefakte, insbesondere die Codebausteine, können in jeder für Steuergeräte geeigneten Programmiersprache abgefasst sein. In dieser Hinsicht wird insbesondere auf die Norm IEC 61131, Teil 3, "Programmiersprachen für Speicherprogrammierbare Steuerungen", verwiesen. Sofern der Quellcode in einer interpretierten Programmiersprache geschrieben ist, wie beispielsweise wenn der Quellcode ein Leiterdiagramm ist, ist der Quellcode notwendigerweise auf dem Steuergerät vorhanden und kann direkt von dort bezogen werden. Sofern der Quellcode in einer compilierbaren Programmiersprache geschrieben ist, wie beispielsweise in C++, und auf dem Steuergerät nur der compilierte Binärcode verfügbar ist, kann der Quellcode von einem Engineering-Werkzeug bezogen werden, in dem der Quellcode gespeichert ist. Der Quellcode kann in dem Engineering-Werkzeug, wie etwa einem Siemens TIA Portal, insbesondere gekennzeichnet als Anlagenwahrheit gespeichert sein, das heißt verknüpft mit einer Angabe, vorzugsweise einer kryptografisch gesicherten Angabe und/oder einer auf kryptografischem Wege, etwa unter Verwendung eines auf dem Steuergerät abgelegten digitalen Schlüssels, nachprüfbaren Angabe, dass es sich bei dem Quellcode tatsächlich um denjenigen Quellcode handelt, aus dem der aktuell auf dem Steuergerät ausgeführte Steuerfunktionalität compiliert wurde.

Die Analyse kann beispielsweise eine semantische und/oder eine syntaktische Analyse des jeweiligen Codeartefakts umfassen, und der hinreichende Detaillierungsgrad kann beispielsweise anhand eines vordefinierten Regelwerks gemäß der semantischen und/oder syntaktischen Analyse festgelegt werden.

Der Begriff "Detaillierungsgrad" bezeichnet insbesondere eine Genauigkeit der mit einem Modell durchführbaren Simulation. Ein Beispiel für ein Modell mit niedrigem Detaillierungsgrad ist ein Totzeitmodell. Ein Beispiel für ein Modell mit hohem Detaillierungsgrad ist ein auf physikalischen Wirkprinzipien beruhendes Modell. In diesem Zusammenhang sei auf die Definition von Detaillierungsgraden bzw. Modellierungstiefen aus der VDI 3693 verwiesen.

Der Begriff "eine Anzahl von" bezieht sich vorliegend auf eine Anzahl von einem oder mehreren Elementen, also eine Anzahl N mit N ≥ 1.

Gemäß einer Ausführungsform umfasst das vorgeschlagene Verfahren ferner: d) Ausbilden einer Hardware-in-the-Loop-Anordnung, die das Steuergerät und den in Schritt c) bereitgestellten digitalen Zwilling umfasst; e) Durchführen mehrerer Testfälle mit der Hardware-in-the-Loop-Anordnung; und f) Ausgeben eines Testfalls, bei dem der Betrieb der semivirtuellen Anlage verbessert ist, und/oder Ändern der Steuerfunktionalität des Steuergeräts und/oder der technischen Anlage gemäß dem Testfall, bei dem der Betrieb der Hardware-in-the-Loop-Anordnung verbessert ist.

Demgemäß ist vorteilhafterweise ein Verfahren angegeben, mit dem der Betrieb der technischen Anlage vollautomatisch verbessert werden kann.

Die Hardware-in-the-Loop-Anordnung kann beispielsweise ausgebildet werden, indem eine Verbindung zwischen der Computervorrichtung, auf welcher der erzeugte digitale Zwilling ausgeführt wird, und dem Steuergerät dergestalt hergestellt oder geschaltet wird, dass das Steuergerät Ausgangssignale an den digitalen Zwilling anstelle der technischen Anlage ausgibt und Eingangssignale von dem digitalen Zwilling anstelle der technischen Anlage empfängt. Das Herstellen oder Schalten der Verbindung kann manuell oder auch automatisch durch einen Roboter, durch elektronisches Schalten oder dergleichen erfolgen.

Unter einem "Testfall" ist insbesondere eine zu testende veränderte Konfiguration der Steuerfunktionalität und/oder der technischen Anlage zu verstehen. Im Rahmen des Testfalls können beispielsweise Parameter der Steuerfunktionalität angepasst sein oder es kann ein durchzutestender Parameterbereich durchgetestet werden; auch ist denkbar, im Rahmen des Testfalls eine veränderte Steuerfunktionalität, bei denen einige oder alle der Codeartefaktakte verändert oder aktualisiert sind, zu testen; und es ist denkbar, einzelne Modelle des digitalen Zwillings durch geänderte Modelle, die geänderte Anlagenkomponenten modellieren, zu ersetzen.

Die mehreren Testfälle können von einem Betreiber der technischen Anlage gemäß seinen Änderungswünschen vorgegeben werden. Es ist jedoch auch denkbar, eine Menge aller mit dem digitalen Zwilling modellierbaren Testfälle automatisch zu bestimmen und alle durchführbaren Testfälle durchzuführen.

Das "Durchführen eines Testfalls" kann demgemäß umfassen, die angepassten Parameter und/oder die veränderten Codeartefakte vorübergehend auf dem Steuergerät zu implementieren und/oder die veränderten Modelle in dem digitalen Zwilling zu implementieren und sodann den digitalen Zwilling, welcher die technische Anlage modelliert, mit dem Steuergerät als Hardware-in-the-Loop-Anordnung zu betreiben.

Ein Testfall, bei dem der Betrieb der Hardware-in-the-Loop-Anordnung verbessert, ist auch ein Testfall, bei dem realistisch zu erwarten ist, dass der Betrieb der technischen Anlage verbessert ist. Unter "verbessertem Betrieb" ist hierbei insbesondere zu verstehen, dass wenigstens ein Leistungsparameter verbessert ist. Der Leistungsparameter kann einer der vorgegebenen Parameter der Steuerfunktionalität sein, wie etwa eine erhöhte Taktrate, die sich beim Durchführen des Testfalls als ohne Fehlerzustände durchführbar erwiesen hat. Der Leistungsparameter kann auch ein beim Durchführen des Testfalls an dem digitalen Zwilling gemessener Parameter sein, wie etwa eine verringerte Ausschussrate oder dergleichen.

Entsprechend kann "Ändern der Steuerfunktionalität" umfassen, dass die angepassten Parameter und/oder die veränderten Codeartefakte desjenigen Testfalls, bei dem der Betrieb der Hardware-in-the-Loop-Anordnung verbessert ist, dauerhaft auf dem Steuergerät implementiert werden und die entsprechend veränderten Parameter und/oder veränderten Codeartefakte auf einem Engineering-Werkzeug als neue Anlagenwahrheit gespeichert oder markiert werden. "Ändern der technischen Anlage" kann entsprechend umfassen, eine Anlagenkomponente gegen eine geänderte Anlagenkomponente auszutauschen, was manuell oder automatisiert beispielsweise mithilfe eines Roboters erfolgen kann.

In einem Fall, in dem der Testfall, bei dem der Anlagenbetrieb verbessert ist, lediglich ausgegeben wird, kann dieser beispielsweise in einem maschinenlesbaren Format ausgegeben werden, so dass es sich bei dem ausgegebenen Testfall um funktionale Daten handeln kann, die dafür vorgesehen sind, ein Modellierungstool zur automatischen Generierung eines entsprechend angepassten digitalen Zwillings und/oder angepasster Steuerungsfunktionalität zu veranlassen.

Gemäß einer weiteren Ausführungsform umfassen die in Schritt a) extrahierten Codeartefakte Codebausteine, Schnittstellendefinitionen der Codebausteine und Eingangs- und Ausgangssignaldefinitionen und in Schritt b) erfolgt die Analyse insbesondere basierend auf den Schnittstellendefinitionen und/oder den Eingangs- und Ausgangssignaldefinitionen.

Die Erfinder haben erkannt, dass bereits aus den Schnittstellendefinitionen und/oder Eingangs- und Ausgangssignaldefinitionen valide Rückschlüsse auf den erforderlichen Detaillierungsgrad des Modells der jeweiligen Anlagenkomponente gezogen werden können, so dass die Analyse in Schritt b) vorteilhafterweise besonders einfach erfolgen kann. Zudem kann eine solche Analyse der Schnittstellendefinitionen und/oder der Eingangs- und Ausgangssignaldefinitionen eine Zuordnung der Codebausteine zu jeweiligen der Anlagenkomponenten ermöglichen.

Gemäß einer weiteren Ausführungsform umfasst in Schritt b) die Analyse eine syntaktische Analyse der Codeartefakte.

Die syntaktische Analyse kann insbesondere eine Analyse von Datentypen (Wahrheitswert, Ganzzahl, Fließkommawert etc.) und/oder Bit-Mächtigkeiten der jeweiligen Schnittstellendefinitionen der Codebausteine umfassen.

Demgemäß kann vorteilhafterweise von der Syntax der Schnittstellendefinitionen auf den hinreichenden Detaillierungsgrad geschlossen werden.

Gemäß einer weiteren Ausführungsform wird in Schritt b) im Rahmen der syntaktischen Analyse der jeweilige Detaillierungsgrad entsprechend einer Bit-Mächtigkeit der entsprechenden Schnittstellendefinition bestimmt.

Demgemäß kann vorteilhaft erkannt werden, wie genau die den Schnittstellen von dem digitalen Zwilling bereitzustellende oder von diesen entgegenzunehmende Signale zu modellieren sind.

Gemäß einer weiteren Ausführungsform umfasst in Schritt b) die Analyse eine semantische Analyse der Codeartefakte.

Unter einer semantischen Analyse ist insbesondere zu verstehen, dass für die Analyse auch die Benennungen von Schnittstellendefinitionen, Eingangs- und Ausgangssignalen und Codebausteinen erfasst. Solche Benennungen sind häufig als Betriebsmittelkennzeichen standardisiert und erlauben daher vorteilhafterweise eine Analyse, die Zusammenhänge zwischen den verschiedenen Codeartefakten erfasst und erlauben beispielsweise auch eine regelbasierte Analyse, die Rückschlüsse auf den erforderlichen Detaillierungsgrad erlaubt.

Gemäß einer weiteren Ausführungsform erfolgt in Schritt b) im Rahmen der semantischen Analyse zum Bestimmen des jeweiligen Detaillierungsgrads eine regelbasierte Analyse der Codeartefakte.

Wenn die semantische Benennung der Codebausteine, Schnittstellendefinitionen und Eingangs- und Ausgangssignaldefinitionen in dem Quellcode standardisiert ist, kann die Analyse vorteilhafterweise anhand eines Regelwerks erfolgen, das den standardisierten Benennungen entsprechende Zugehörigkeiten, notwendige und hinreichende Detaillierungsgrade und dergleichen zuordnet. Somit kann vorteilhafterweise vorhandenes Wissen über notwendige Detaillierungsgrade bei der Modellierung mittels digitaler Zwillinge nutzbar gemacht werden.

Gemäß einer weiteren Ausführungsform ist der jeweilige Detaillierungsgrad ausgewählt aus einer Menge, die mindestens einen niedrigen Detaillierungsgrad, der einem Eingabe-Ausgabe-Modell entspricht, und einen hohen Detaillierungsgrad umfasst, der einer Modellierung basierend auf physikalischen Wirkprinzipien entspricht.

Ein Eingabe-Ausgabe-Modell ist insbesondere ein Modell, das physikalische Wirkprinzipien außer acht lässt und die zu modellierende Anlagenkomponente rein anhand ihres beobachteten Eingabe- und Ausgabe-Verhaltens modelliert. Ein Totzeitmodell ist ein Beispiel für ein Eingabe-Ausgabe-Modell.

Eine Modellierung basierend auf physikalischen Wirkprinzipien ist demgegenüber ein Modell, das innere Abläufe der jeweiligen Anlagenkomponente basierend auf der tatsächlichen Struktur der Anlagenkomponente und einem theoretischen Modell der in ihr ablaufenden physikalischen Prozesse modelliert.

Gemäß einem zweiten Aspekt wird ein Computerprogrammprodukt vorgeschlagen, welches Befehle umfasst, die bei der Ausführung des Programms durch einen Computer diesen veranlassen, das vorstehend beschriebene Verfahren auszuführen.

Es versteht sich, dass der Computer hierbei ein Computer ist, der kommunikativ mit dem Steuergerät, mit der technischen Anlage, mit einem Engineering-Werkzeug, in welchem der Quellcode abrufbar ist, und dergleichen verbindbar oder verbunden ist.

Ein Computerprogrammprodukt, wie z. B. ein Computer-programm-Mittel, kann beispielsweise als Speichermedium, wie z. B. Speicherkarte, USB-Stick, CD-ROM, DVD, oder auch in Form einer herunterladbaren Datei von einem Server in einem Netzwerk bereitgestellt oder geliefert werden. Dies kann zum Beispiel in einem drahtlosen Kommunikationsnetzwerk durch die Übertragung einer entsprechenden Datei mit dem Computerprogrammprodukt oder dem Computerprogramm-Mittel erfolgen.

Gemäß einem dritten Aspekt wird eine computerisierte Vorrichtung zum Analysieren und/oder Anpassen eines Betriebs einer technischen Anlage mit einer Anzahl von Anlagenkomponenten und eines Steuergeräts zum Steuern der technischen Anlage vorgeschlagen, wobei die computerisierte Vorrichtung umfasst: a) eine erste Einheit, die dazu eingerichtet ist, einen Quellcode einer auf dem Steuergerät ausgeführten Steuerfunktionalität zu erlangen und Codeartefakte aus dem erlangten Quellcode zu extrahieren; b) eine zweite Einheit, die dazu eingerichtet ist, eine Analyse der in Schritt a) extrahierten Codeartefakte durchzuführen und einen hinreichenden Detaillierungsgrad eines Modells zum Modellieren der jeweiligen Anlagenkomponente basierend auf der durchgeführten Analyse zu bestimmen; und c) eine dritte Einheit, die dazu eingerichtet ist, einen digitalen Zwilling der technischen Anlage zur Verwendung beim Analysieren oder Anpassen des Betriebs der technischen Anlage bereitzustellen, wobei der digitale Zwilling für jede der Anlagenkomponenten der technischen Anlage ein entsprechendes Modell umfasst, das gemäß dem jeweiligen in Schritt b) bestimmten Detaillierungsgrad generiert ist.

Die jeweilige Einheit kann hardwaretechnisch und/oder auch softwaretechnisch implementiert sein. Bei einer hardwaretechnischen Implementierung kann die jeweilige Einheit als Vorrichtung oder als Teil einer Vorrichtung, zum Beispiel als Computer oder als Mikroprozessor oder als Steuerrechner eines Fahrzeuges ausgebildet sein. Bei einer softwaretechnischen Implementierung kann die jeweilige Einheit als Computerprogrammprodukt, als eine Funktion, als eine Routine, als Teil eines Programmcodes oder als ausführbares Objekt ausgebildet sein.

Die für das vorgeschlagene Verfahren des ersten Aspekts beschriebenen Ausführungsformen, Merkmale und Vorteile gelten entsprechend auch für das vorgeschlagene Computerprogrammprodukt des zweiten Aspekts und die vorgeschlagene Vorrichtung des dritten Aspekts.

In der vorliegenden Beschreibung sind unabhängig vom grammatikalischen Geschlecht eines bestimmten Begriffes Personen mit männlicher, weiblicher oder anderer Geschlechteridentität stets mit umfasst.

Weitere mögliche Implementierungen der Erfindung umfassen auch nicht explizit genannte Kombinationen von zuvor oder im Folgen-den bezüglich der Ausführungsbeispiele beschriebenen Merkmale oder Ausführungsformen. Dabei wird der Fachmann auch Einzelaspekte als Verbesserungen oder Ergänzungen zu der jeweiligen Grundform der Erfindung hinzufügen.

Weitere vorteilhafte Ausgestaltungen und Aspekte der Erfindung sind Gegenstand der Unteransprüche sowie der im Folgenden beschriebenen Ausführungsbeispiele der Erfindung. Im Weiteren wird die Erfindung anhand von bevorzugten Ausführungsformen unter Bezugnahme auf die beigelegten Figuren näher erläutert.
Fig. 1 zeigt eine schematische Darstellung eines industriellen Standorts mit einer technischen Anlage gemäß einem ersten Ausführungsbeispiel;
Fig. 2 zeigt Schritte eines Verfahrens zum Analysieren und/oder Anpassen des Betriebs der technischen Anlage gemäß dem ersten Ausführungsbeispiel;
Fig. 3 zeigt weitere Schritte des vorgeschlagenen Verfahrens gemäß einer Weiterbildung des ersten Ausführungsbeispiels; und
Fig. 4 zeigt Schritte zur Analyse von Codeartefakten gemäß einer weiteren Weiterbildung des ersten Ausführungsbeispiels.

In den Figuren sind gleiche oder funktionsgleiche Elemente mit denselben Bezugszeichen versehen worden, sofern nichts anderes angegeben ist.

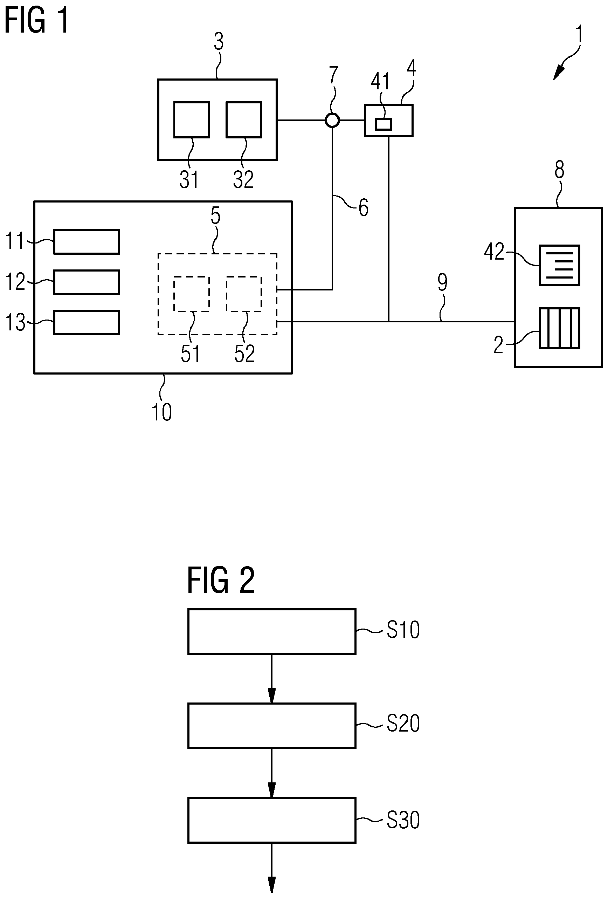

Fig. 1 zeigt eine schematische Darstellung eines industriellen Standorts 1 mit einer technischen Anlage 3 und einem Steuergerät 4. Neben der technischen Anlage 3 und dem Steuergerät 5 zeigt Fig. 1 außerdem eine computerisierte Vorrichtung 10 gemäß dem ersten Ausführungsbeispiel und ein Engineering-Werkezug 8, wie beispielsweise ein Siemens TIA Portal, das an dem industriellen Standort 1 oder extern, beispielsweise in einer Cloud, angeordnet sein kann. Die computerisierte Vorrichtung 10 und das Engineering-Werkzeug 8 werden später beschreiben.

Die technische Anlage 3 umfasst mehrere Anlagenkomponenten 31, 32. Auf dem Steuergerät 4 ist ein Programm 41 installiert, das bei seiner Ausführung durch das Steuergerät 4 eine Steuerfunktionalität implementiert, die den Betrieb der technischen Anlage 3 und im Speziellen der Anlagenkomponenten 31, 32 steuert. Hierzu ist das Steuergerät 4 über ein Steuernetzwerk 6 mit der technischen Anlage 3 verbunden, über welches das Steuergerät 4 Ausgangssignale an die technische Anlage 3 sendet und Eingangssignale von der technischen Anlage 3 empfängt. Das Steuernetzwerk 6 kann ohne Beschränkung der Allgemeinheit beispielsweise eine Signalleitung sein, es kann sich aber auch um ein industrielles Netzwerk wie Feldbus, EtherCAT oder dergleichen oder auch um ein Ethernet handeln.

In einem Brownfield-Szenario, in dem die technische Anlage 3 wie beschreiben bereits in Betrieb ist, kann es erwünscht sein, den Betrieb der technischen Anlage 3 und des Steuergeräts 4 zu analysieren oder anzupassen. Hierbei sollten geplante Änderungen an dem Programm 41 und damit an der Steuerfunktionalität oder auch geplante Änderungen an einer der Anlagenkomponenten 31, 32 vor der Einführung in den Live-Betrieb auf ihre Tauglichkeit überprüft werden, um Fehlfunktionen, Ausfälle, die Produktion von Ausschuss oder Beschädigungen der technischen Anlage 3 bei der Umstellung auf das geänderte Programm 41 (die geänderte Steuerfunktionalität) oder die geänderten Anlagenkomponenten 31, 32 zu vermeiden.

Für eine solche Überprüfung der Auswirkung geplanter Änderungen an der von dem Programm 41 realisierten Steuerfunktionalität oder an den Anlagenkomponenten 31, 32 ist es wünschenswert, einen digitalen Zwilling 5 der technischen Anlage 3 zur Verfügung zu haben, der eine Anzahl von Modellen 51, 52 umfasst, wobei jedes Modell 51, 52 eine jeweilige der Anlagenkomponenten 31, 32 modelliert. Ein solcher digitaler Zwilling 5 kann über das Steuernetzwerk 6 mit dem Steuergerät 4 verbunden werden, und beispielsweise durch Umschalten eines Schalters 7 kann der digitale Zwilling 5 anstelle der Anlagenkomponenten 3 mit dem Steuergerät 4 verbunden werden. Auf diese Weise wird eine Hardware-in-the-Loop-Anordnung aus dem Steuergerät 4 und dem digitalen Zwilling 5 gebildet. Der digitale Zwilling 5 nimmt hierbei über das Steuernetzwerk 6 Ausgangssignale von dem Steuergerät 4 entgegen und stellt dem Steuergerät 5 Eingangssignale bereit und verhält sich dabei annäherend so, wie sich die reale technische Anlage 3 verhalten würden. In einer solchen Hardware-in-the-Loop-Anordnung können Analysen durchgeführt werden und Anpassungen vorgenommen und analysiert werden, ohne dass die reale technische Anlage 3 betrieben werden muss. Auf diese Weise kann die Produktion von Ausschuss, oder können Beschädigungen der Anlagenkomponenten 31, 32 oder dergleichen während der Erprobung von Modifikationen an der technischen Anlage 3 oder an dem Programm 41 des Steuergeräts 4 vorteilhafterweise vermieden werden.

Allerdings ist der Aufwand zur Erstellung eines solchen digitalen Zwillings 5 hoch, dies insbesondere dann, wenn ein Modellierer davon ausgeht, alle Anlagenkomponenten 31, 32 mit dem bestmöglichen Detaillierungsgrad modellieren zu müssen, das heißt, wenn der Modellierer versucht die physikalischen Wirkprinzipien der Arbeit der jeweiligen Anlagenkomponenten 31, 32 exakt und detailgetreu zu modellieren und zu simulieren. Aufgrund dieses hohen Aufwands wurde bisher in Brownfield-Szenarien mit Losgröße 1 von der Verwendung von digitalen Zwillingen 5 häufig Abstand genommen.

Um dieser Situation Abhilfe zu schaffen, ist gemäß dem ersten Ausführungsbeispiel die computerisierte Vorrichtung 10 beigestellt, die die Erstellung eines digitalen Zwillings 5 mit einem reduzierten, tatsächlich hinreichenden Detaillierungsgrad ermöglicht.

Fig. 2 zeigt Schritte eines Verfahrens zum Analysieren und/oder Anpassen des Betriebs der technischen Anlage 3 gemäß dem ersten Ausführungsbeispiel. Es wird nun auf Fig. 1 und Fig. 2 Bezug genommen und die vorgeschlagene Lösung gemäß dem ersten Ausführungsbeispiel beschrieben.

Die computerisierte Vorrichtung 10 ist einerseits über das Steuernetzwerk 6 und den Schalter 7 mit der Steuervorrichtung 4 verbindbar. Andererseits ist die computerisierte Vorrichtung 10 über ein Datennetzwerk 9, wie ein Ethernet, ein Intranet, das Internet oder dergleichen, einerseits mit der Steuervorrichtung 4 und andererseits mit dem Engineering-Werkzeug 8 verbunden.

In Schritt S10 bezieht eine erste Einheit 11 der computerisierten Vorrichtung 10 von dem Engineering-Werkzeug 8 einen Quellcode 42 des Programms 41 bzw. der von dem Programm 41 ausgebildeten Steuerfunktionalität. Es sei angemerkt, dass der Quellcode 42 auf dem Engineering-Werkzeug 8 als zu dem Steuergerät 4 und der technischen Anlage 3 zugehörige Anlagenwahrheit gekennzeichnet sein kann, wozu kryptografische Methoden benutzt werden können, wie eine digitale Signatur, die mit einem öffentlichen Schlüssel des Steuergeräts 4 oder einem öffentlichen Schlüssel eines vertrauenswürdigen Entwicklers verifiziert werden kann. Auf diese Weise kann die erste Einheit 11 sicher sein, dass der bezogene Quellcode 42 tatsächlich dem auf dem Steuergerät 4 ausgeführten Programm 41 entspricht. Sodann extrahiert die erste Einheit 11 Codeartefakte aus dem erlangten Quellcode 42. Bei den Codeartefakten kann es sich um Codebausteine, Schnittstellendefinitionen der Codebausteine, Eingangs- und Ausgangssignaldefinitionen und dergleichen handeln.

In Schritt S20 führt eine zweite Einheit 12 der computerisierten Vorrichtung 10 eine Analyse der in Schritt S10 extrahierten Codeartefakte durch. Im Rahmen dieser Analyse, bei der syntaktische und/oder semantische Analyseverfahren zum Einsatz kommen können, werden beispielsweise die Codeartefakte, insbesondere die Codebausteine, den einzelnen Anlagenkomponenten 31, 32 zugeordnet und anhand der Eingangs- und Ausgangssignaldefinitionen und der Schnittstellendefinitionen wird aus der Art und Weise der Kommunikation zwischen den einzelnen Codebausteinen bzw. Anlagenkomponenten 31, 32 auf den erforderlichen und hinreichenden Detaillierungsgrad geschlossen, mit dem die jeweilige Anlagenkomponente 31, 32 zu modellieren ist.

In Schritt S30 stellt eine dritte Einheit 13 automatisch den digitalen Zwilling 5 bereit. Hierbei generiert die dritte Einheit 13 den digitalen Zwilling 5 dergestalt, dass der digitale Zwilling für jede der Anlagenkomponenten 31, 32 ein entsprechendes Modell 51, 52 umfasst, das einen Detaillierungsgrad aufweist, der dem in Schritt S20 bestimmten hinreichenden Detaillierungsgrad entspricht. Beispielsweise kann die dritte Einheit 13 anhand der bei der Analyse in Schritt S20 bestimmten semantischen Bezeichnungen der Anlagenkomponenten 31, 32 aus einer auf dem Engineering-Werkzeug 8 abgelegten Modellbibliothek 2 die Modelle 51, 52 beziehen. Hierbei kann die Modellbibliothek2 Modelle unterschiedlichen Detaillierungsgrades für jede der Anlagenkomponente 31, 32 vorhalten und die dritte Einheit 13 kann dasjenige Modell 51, 52 mit dem in Schritt S20 bestimmten Detaillierungsgrad auswählen. Die Modelle in der Modellbibliothek 2 können speziell auf die einzelnen Anlagenkomponenten 31, 32 der technischen Anlage 3 abgestimmte Modelle sein. Es ist auch denkbar, dass die Modellbibliothek 2 lediglich generische Modelle enthält, die von der dritten Einheit 13 gemäß bei der Analyse in Schritt S20 gewonnenen Informationen parametrisiert und dadurch in die Modelle 51, 52 überführt werden.

Der solchermaßen automatisch zusammengestellte digitale Zwilling 5 steht sodann auf der computerisierten Vorrichtung 10 bereit, und ein Anlagenbetreiber der technischen Anlage 3 kann durch Umschalten des Schalters 7 eine Hardware-in-the-Loop-Anordnung aus dem digitalen Zwilling (der computerisierten Vorrichtung 10) und dem Steuergerät 4 bilden und Analysen durchführen oder Anpassungen der Modelle 51, 52 oder des Programms 41 vornehmen und die Auswirkungen dieser Anpassungen analysieren.

Somit ist vorteilhafterweise der Aufwand zur Erstellung eines digitalen Zwillings 5 in einem Brownfield-Szenario deutlich reduziert.

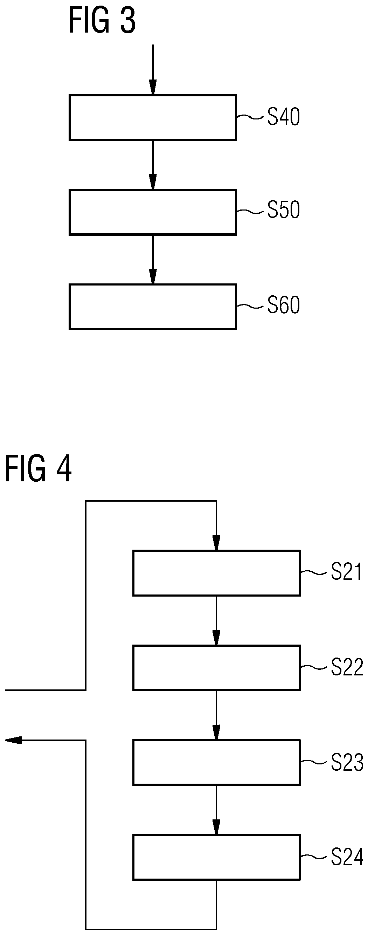

Fig. 3 veranschaulicht weitere Schritte des vorgeschlagenen Verfahrens gemäß einer Weiterbildung des ersten Ausführungsbeispiels. Es wird auf Fig. 1 bis Fig. 3 Bezug genommen.

Die Schritte S40, S50, S60 können zum Beispiel von einer (nicht gezeigten) vierten, fünften und sechsten Einheit der computerisierten Vorrichtung 10 durchgeführt werden.

In Schritt S40 wird, nachdem in Schritt S30 der digitale Zwilling 5 bereitgestellt wurde, durch Umschalten des Schalters 7 eine Hardware-in-the-Loop-Anordnung ausgebildet, die das Steuergerät 4 und den in Schritt S30 bereitgestellten digitalen Zwilling 5 umfasst.

Sodann werden in Schritt S50 mehrere Testfälle mit der in Schritt S40 ausgebildeten Hardware-in-the-Loop-Anordnung durchgeführt. Die Testfälle können von einem Anlagenbetreiber bereitgestellt oder automatisch als durchführbar ermittelt werden. Beim Durchführen eines jeden der mehreren Testfälle wird ein Leistungsparameter bestimmt, der eine Qualität des Betriebs der technischen Anlage 3 bzw. der Hardware-in-the-Loop-Anordnung angibt. Dies kann ein vorgegebener oder ein gemessener Parameter sein, wie etwa eine Taktzeit, ein Durchsatz, eine Ausschussrate, eine Online- oder Standzeit, oder dergleichen.

In Schritt S60 schließlich wird derjenige der mehreren Testfälle ausgegeben, bei dem der Leistungsparameter am meisten verbessert ist. Der Testfall kann in einem maschinenlesbaren Format bereitgestellt werden. Es ist auch denkbar, den Testfall, bei dem der Leistungsparameter am meisten verbessert ist, direkt und automatisch auf das technische Gerät 3 und das Steuergerät 4 zu übernehmen, indem Betriebsparameter, die im Rahmen des Testfalls modifiziert werden, dauerhaft auf das Steuergerät 4 übernommen werden, indem Anlagenkomponenten 31, 32, gemäß an den Modellen 51, 52 im Rahmen des Testfalls vorgenommenen Veränderungen ausgetauscht oder umkonfiguriert werden, und dergleichen.

Demgemäß kann ein Betrieb der technischen Anlage 3 vorteilhafterweise automatisch verbessert werden. Hierbei wird vorteilhafterweise ein digitaler Zwilling 5 mit hinreichendem Detaillierungsgrad verwendet und die Verwendung von unnötig aufwendigen und detaillierten Modellen 51, 52 vermieden.

Es werden nun weitere vorteilhafte Weiterbildungen beschrieben, in deren Rahmen vorteilhafte Details der Analyse in Schritt S20 besprochen werden. Es wird weiter auf Fig. 1 und Fig. 2 Bezug genommen.

Ein mögliches Prinzip der Analyse in Schritt S20 lässt sich wie folgt beschreiben: Werden für eine Ansteuerung einer Anlagenkomponente 31, 32 beispielsweise ausschließlich Binär-Sensoren/Aktoren in der Strecke genutzt, braucht das entsprechende Modell 51, 52 des digitalen Zwillings 5, der mit dem Steuergerät 4 zusammenwirkt, nicht sehr detailliert zu sein, da es nur einen sehr begrenzten Lösungsraum gibt (nämlich an/aus). Werden dagegen Sensoren/Aktoren unterschiedlicher Qualität genutzt, beispielsweise ein mittels Schützen angesteuerter Motor und ein Absolutwertgeber in Kombination, oder ein Frequenzumrichter mit umfangreicher Sensorik zur Positionsbestimmung, so ist der mögliche Lösungsraum sehr viel größer. Um den größeren Lösungsraum abbilden zu können, wird ein entsprechend detaillierteres Modell 51, 52 in dem digitalen Zwilling 5 benötigt als im ersteren Falle.

Wie vorstehend erwähnt, werden in Schritt S10 Codebausteine (wie Subroutinen, Klassen und dergleichen), Schnittstellendefinitionen dieser Codebausteine, und Listen mit Eingangs- und Ausgangssignaldefinitionen der Eingangs- und Ausgangssignale des Steuergeräts 4 aus dem Quellcode 42 extrahiert.

Fig. 4 veranschaulicht in diesem Zusammenhang Details zu Schritt S20 gemäß einer weiteren Weiterbildung des ersten Ausführungsbeispiels. Es wird auf Fig. 1 bis Fig. 4 Bezug genommen.

In Teilschritt S21 von Schritt S20 werden aus den in Schritt S10 extrahierten Informationen n-Tupel von Eingangs- und Ausgangssignaldefinitionen und den korrespondierenden Codebausteinen erzeugt. Hierfür werden die Ausgangs- und Eingangsliste auf semantische Überschneidungen hin überprüft, z. B. ähnliches Betriebsmittelkennzeichen, Zusammengehörigkeit zu einer bestimmten Funktion/Apparatur/Gerät/etc. Die als zusammengehörig erkannten Eingangs- und Ausgangssignaldefinitionen werden mit den Schnittstellendefinitionen der Codebausteine verknüpft, die diese Aus- und Eingangssignale verwenden.

In Teilschritt S22 werden die in Teilschritt S21 gebildeten Tupel in Abhängigkeit der Zusammenhänge zwischen Eingangsgröße, Ausgangsgröße und dem Codebaustein, an denen diese verwendet werden, analysiert. Die Analyse erfolgt anhand von Aussagen wie Binär-Binär, Binär-Byte/Wort/Doppel Wort/... und allen möglichen sich ergebenden Kombinationen. Die Information wird zusätzlich unter Beachtung der Semantik der Ein- bzw. Ausgangssignaldefinition analysiert. Die Ermittlung des Detaillierungsgrads erfolgt zweistufig. Zunächst wird die Semantik analysiert für eine grobe Einordnung der Ein- bzw. Ausgangsgrößen (z. B. Lichtschranke, Schütz, Umrichter, ...). Diese Information wird nun mit der Bit-Mächtigkeit der Schnittstellendefinition (Binär, Wort, Doppel Wort, ...) in Beziehung gesetzt. Dadurch können einfache Anlagenkomponenten 31, 32 (z. B. Lichtschranke als Binärsignal an/aus) wie auch komplexe Anlagenkomponenten 31, 32 (Lichtschranke mit Abstandsmessung und Doppel-Wort-Eingang) voneinander unterschieden werden, auch wenn die Semantik keine Unterscheidung zulassen würde.

In Teilschritt S23 erfolgt sodann eine konkrete Zuweisung eines Detaillierungsgrads anhand eines vorher festgelegten Regelwerks. Ein Beispiel für eine solche Regel könnte lauten: "(Lichtschranke und Schnittstelle mit Doppel-Wort-Eingang) + (Umrichter mit Schnittstelle mit mehreren Prozessdatenwörtern) = (Baustein, an dem die Ein- und Ausgangsgrößen anparametriert sind, muss mit Modell von Detaillierung X gekoppelt werden)". Die Verknüpfung zwischen Kombination und Detaillierungsgrad ist auch von der verfügbaren Modellbibliothek 2 abhängig, so dass diese von einem Nutzer vorher festgelegt werden kann.

Ein konkretes Beispiel für die Auswahl eines Detaillierungsgrads könnte wie folgt aussehen: Eine Schwenkhebevorrichtung für eine Automobilproduktionsstraße kann beispielsweise eine Schützwendesteuerung (Anlagenkomponente) aufweisen. Diese wird mit drei binären Ausgangssignalen angesteuert: Motor an, Motor aus, und Drehrichtung, was dem Quellcode 42 entnommen werden kann. Hier würde sich die Verwendung eines Eingabe-Ausgabe-Modells wie etwa eines Totzeitmodells (Modell mit niedrigem Detaillierungsgrad) anbieten und wäre hinreichend. Sofern jedoch in dem Quellcode 42 erkannt wird, dass die Schwenkhebevorrichtung weiterhin einen Winkelgeber aufweist und dieser ein Eingangssignal in Form eines 32-Bit-Doppelworts bereitstellt, ist davon auszugehen, dass die exakte Drehposition von Bedeutung ist. Dementsprechend ist eine Modellierung basierend auf physikalischen Wirkprinzipien, wie etwa anhand von Potential und Flussgrößen und dergleichen, (Modell mit hohem Detaillierungsgrad) erforderlich.

In Teilschritt S24 wird aufbauend auf den in Teilschritten S22 und S23 gefundenen Erkenntnissen jedem n-Tupel die Information hinzugefügt, welcher Detaillierungsgrad in Kombination mit einer bestimmten Anlagenkomponente 31, 32 mindestens erforderlich und hinreichend ist.

In Schritt S30 gemäß der vorliegenden vorteilhaften Weiterbildung können sodann die Schnittstellen der Simulationsmodelle, die in der Modellbibliothek 2 vorliegen, wie sie etwa in einer Co-Simulation mit FMU vorliegen, automatisch auf ihre Detaillierungsgrad-Erfüllung syntaktisch und semantisch überprüft werden. Demgemäß kann gemäß den in Teilschritt S24 festgelegten Detaillierungsgraden aus der Modellbibliothek 2 ein geeignetes Modell zur Verwendung als Modell 51, 52 des digitalen Zwillings 5 ausgewählt werden.

Ferner kann, falls der optionale Schritt S50 ausgeführt wird, auch aus den solchermaßen erlangten Informationen abgeleitet werden, welche Testfälle mit dem fraglichen Modell 51, 52 durchführbar sind.

Gemäß der vorstehend beschriebenen vorteilhaften Weiterbildung erfolgt somit insbesondere eine syntaktische und eine semantische Analyse der aus dem Quellcode 42 extrahierten Codeartefakte, insbesondere der Schnittstellendefinitionen und der Eingangs- und Ausgangssignaldefinitionen. Insbesondere wird gemäß der vorstehend beschriebenen vorteilhaften Weiterbildung der jeweilige Detaillierungsgrad des jeweiligen Modells 51, 52 entsprechend einer Bit-Mächtigkeit der entsprechenden Schnittstellendefinition des oder der zu dem jeweiligen Anlagenkomponente 31, 32 zugehörigen Codebausteine bestimmt. Insbesondere wird gemäß der vorstehend beschriebenen vorteilhaften Weiterbildung der jeweilige Detaillierungsgrad durch eine regelbasierte Analyse der Codeartefakte ermittelt.

Obwohl die vorliegende Erfindung anhand von Ausführungsbeispielen beschrieben wurde, ist sie vielfältig modifizierbar.

So wird beispielsweise in Fig. 1 gezeigt, dass der Quellcode 42 von einem Engineering-Werkzeug 8 bezogen wird. Der Quellcode 8 kann jedoch auch direkt von dem Steuergerät 4 bezogen werden, sofern er dort vorhanden ist, weil etwa das Programm 41 ein interpretiertes Programm ist, das im Quellcode vorliegt, oder weil das Steuergerät 4 über einen integrierten Compiler verfügt und der Quellcode 42 auch im Steuergerät 4 als Anlagenwahrheit abgelegt ist.

Auch braucht der digitale Zwilling 5 nicht auf der computerimplementierten Vorrichtung 10 bereitgestellt zu werden, sondern kann zum Beispiel auch in einer Cloud bereitgestellt werden.

Die vorgeschlagene computerisierte Vorrichtung 10 ist in Fig. 1 als separate Vorrichtung gezeigt, sie kann jedoch auch in das Steuergerät 4 integriert sein oder alternativ auch in das Engineering-Werkzeug 8 integriert sein.

Der Schutzumfang der Erfindung soll durch die vorstehende Figurenbeschreibung nicht eingeschränkt werden, sondern wird durch die nachstehenden Ansprüche angegeben.

## Patentansprüche

1. Computerimplementiertes Verfahren zum Analysieren und/oder Anpassen eines Betriebs einer technischen Anlage (3) mit einer Anzahl von Anlagenkomponenten (31, 32) und eines Steuergeräts (4) zum Steuern der technischen Anlage (3), umfassend:
a) Erlangen (S10) eines Quellcodes (42) einer auf dem Steuergerät (4) ausgeführten Steuerfunktionalität und Extrahieren von Codeartefakten aus dem erlangten Quellcode (42);
b) Durchführen (S20) einer Analyse der in Schritt a) extrahierten Codeartefakte und Bestimmen eines hinreichenden Detaillierungsgrads eines Modells (51, 52) zum Modellieren einer jeweiligen der Anlagenkomponenten (31, 32) basierend auf der durchgeführten Analyse;
c) Bereitstellen (S30) eines digitalen Zwillings (5) der technischen Anlage (3) zur Verwendung beim Analysieren und/oder Anpassen des Betriebs der technischen Anlage (3), wobei der digitale Zwilling (5) für jede der Anlagenkomponenten (31, 32) der technischen Anlage (3) ein entsprechendes Modell (51, 52) umfasst, das gemäß dem jeweiligen in Schritt b) bestimmten Detaillierungsgrad generiert ist.

2. Verfahren nach Anspruch 1,
**gekennzeichnet durch**:
d) Ausbilden (S40) einer Hardware-in-the-Loop-Anordnung, die das Steuergerät (4) und den in Schritt c) bereitgestellten digitalen Zwilling (5) umfasst;
e) Durchführen (S50) mehrerer Testfälle mit der Hardware-in-the-Loop-Anordnung (4, 5); und
f) Ausgeben (S60) eines der mehreren Testfälle, bei dem der Betrieb der technischen Anlage (3) verbessert ist und/oder Ändern der Steuerfunktionalität des Steuergeräts (4) und/oder der technischen Anlage (3) gemäß dem Testfall, bei dem der Betrieb der technischen Anlage (3) verbessert ist.

3. Verfahren nach Anspruch 1 oder 2,
**dadurch gekennzeichnet, dass**
die in Schritt a) extrahierten Codeartefakte Codebausteine, Schnittstellendefinitionen der Codebausteine und Eingangs- und Ausgangssignaldefinitionen umfassen und
in Schritt b) die Analyse insbesondere basierend auf den Schnittstellendefinitionen und/oder den Eingangs- und Ausgangssignaldefinitionen erfolgt.

4. Verfahren nach einem der Ansprüche 1 bis 3,
**dadurch gekennzeichnet, dass**
in Schritt b) die Analyse eine syntaktische Analyse der Codeartefakte umfasst.

5. Verfahren nach Anspruch 4,
**dadurch gekennzeichnet, dass**
in Schritt b) im Rahmen der syntaktischen Analyse der jeweilige Detaillierungsgrad entsprechend einer Bit-Mächtigkeit der entsprechenden Schnittstellendefinition bestimmt wird.

6. Verfahren nach einem der Ansprüche 1 bis 5,
**dadurch gekennzeichnet, dass**
in Schritt b) die Analyse eine semantische Analyse der Codeartefakte umfasst.

7. Verfahren nach Anspruch 6,
**dadurch gekennzeichnet, dass**
in Schritt b) im Rahmen der semantischen Analyse zum Bestimmen des jeweiligen Detaillierungsgrads eine regelbasierte Analyse der Codeartefakte erfolgt.

8. Verfahren nach einem der Ansprüche 1 bis 7,
**dadurch gekennzeichnet, dass**
der jeweilige Detaillierungsgrad ausgewählt ist aus einer Menge, die mindestens einen niedrigen Detaillierungsgrad, der einem Eingabe-Ausgabe-Modell entspricht, und einen hohen Detaillierungsgrad umfasst, der einer Modellierung basierend auf physikalischen Wirkprinzipien entspricht.

9. Computerprogrammprodukt, welches Befehle umfasst, die bei der Ausführung des Programms durch einen Computer diesen veranlassen, das Verfahren nach einem der Ansprüche 1 bis 8 auszuführen.

10. Computerisierte Vorrichtung (10) zum Analysieren und/oder Anpassen eines Betriebs einer technischen Anlage (3), die eine Anzahl von Anlagenkomponenten (31, 32) und ein Steuergerät (4) zum Steuern der Anlagenkomponenten (31, 32) aufweist, umfassend:
a) eine erste Einheit (11), die dazu eingerichtet ist, einen Quellcode (42) einer auf dem Steuergerät (4) ausgeführten Steuerfunktionalität zu erlangen und Codeartefakte aus dem erlangten Quellcode (42) zu extrahieren;
b) eine zweite Einheit (12), die dazu eingerichtet ist, eine Analyse der in Schritt a) extrahierten Codeartefakte durchzuführen und einen hinreichenden Detaillierungsgrad eines Modells (51, 52) zum Modellieren der jeweiligen Anlagenkomponente (31, 32) basierend auf der durchgeführten Analyse zu bestimmen; und
c) eine dritte Einheit (13), die dazu eingerichtet ist, einen digitalen Zwilling (5) der technischen Anlage (3) zur Verwendung beim Analysieren oder Anpassen des Betriebs der technischen Anlage (3) bereitzustellen, wobei der digitale Zwilling (5) für jede der Anlagenkomponenten (31, 32) der technischen Anlage (3) ein entsprechendes Modell (51, 52) umfasst, das gemäß dem jeweiligen in Schritt b) bestimmten Detaillierungsgrad generiert ist.
